# EUROPEAN PATENT SPECIFICATION

(11) **EP 2 408 251 B1**
(45) Date of publication and mention of the grant of the patent: **04.12.2019**
(21) Application number: 11166819.0
(22) Date of filing: 20.05.2011
(51) Int. Cl.: H04B 7/06, H04W 92/20

(54) **Wireless access system**
Drahtloses Zugangssystem
Système d'accès sans fil

(30) Priority: 12.07.2010 JP 2010151329
(43) Date of publication of application: 18.01.2012
(73) Proprietor: Ricoh Company, Ltd., Tokyo 143-8555 (JP)
(72) Inventor: Nakamura, Masaru, Tokyo 143-8555 (JP)
(74) Representative: SSM Sandmair

(56) References cited:
- EP-A1- 1 870 819
- WO-A1-2007/147353
- WO-A2-2004/038984
- JP-A- 2003 318 808
- JP-A- 2009 055 413
- US-A1- 2009 279 523

## Description

### BACKGROUND OF THE INVENTION

### FIELD OF THE INVENTION

The present invention relates to a wireless access system using a space-divisionmultiple access communication as multiple wireless communication.

### DISCUSSION OF THE RELATED ART

Conventionally, as disclosed in Japanese Patent No. 3926669, a wireless access system including a wireless control station and at least one wireless terminal device is known, in which the wireless control station transmits data in compliance with each of the wireless terminal devices through space-division multiple access communication. Meanwhile, data transmission to a wireless terminal device located in each directional space divided by space-division multiple access communication control is exclusively permitted, and time-division data are transmitted to the wireless control station while the wireless terminal device is permitted to transmit data by the wireless control station.

In the conventional wireless access system, data are transmitted from the wireless control station to the wireless terminal device through space-division multiple access communication in down transmission, and from the wireless terminal device to the wireless control station through time-divisionmultiple access communication in up transmission. Therefore, in multiple access communication between the wireless control station and the wireless terminal device, interference between wireless transmission signals from the wireless terminal device is prevented, and interference waves at the wireless control station do not need removing.

However, multiple access communication between plural wireless control stations and wireless terminal devices is not considered.

In particular, a feasible technology for sharing one wireless terminal device among plural wireless control stations and controlling access is not disclosed.

WO 2004/038984 A2 pertains to a multiple-input multiple-output (MIMO) communication system with multiple transmission modes.

WO 2007/147353 A1 pertains to a wireless access system according to the preamble of claim 1.

JP 2009 055413 A discloses a printer device that comprises a radio communication section of a MIMO communication system and receives a signal from a mobile personal computer (PC). When communication starts, a distance measuring section measures the distance to the PC and dispatches the distance to a control section. The control section decides whether the distance is greater than a prescribed value and controls a space time coding/space division multiplexing (STC/SDM) mode selecting section. The STC/SDM mode selecting section selects either an STC communication section or an SDM communication section, in accordance with the control and switches thereto. Communication is performed by the communication section which has been switched. The communication mode can be selected and switched according to the reception power intensity, a reception error rate, and the like, in addition to the distance.

JP 2003 318808 A provides a radio communication system and a radio access method using an SDMA (space division multiple access) communication method in which interference between terminals is prevented without requiring interference wave removal processing in a radio base station device in multiplex radio communication.

The present invention is defined by the subject-matter of the appended claims.

Accordingly, an object of the present invention is to provide a wireless access system capable of preventing interference with wireless transmission signals between the wireless control stations without needing removal of interference waves in the wireless terminal device in multiple wireless communication between plural wireless control stations and wireless terminal devices.

Another object of the present invention is to provide a wireless terminal device.

A further object of the present invention is to provide a wireless access method.

To achieve such objects, the present invention contemplates the provision of a wireless access system, comprising:
plural wireless control stations;
a wireless terminal device to transmit and receive data to and from the plural wireless control stations,
wherein the wireless control stations adjust with each other to reserve data transmission periods so as not to overlap with those of the other wireless control stations and transmit data in the reserved periods, and
the wireless terminal device transmits data to at least one of the wireless control stations through space-division multiple access communication.

These and other objects, features and advantages of the present invention will become apparent upon consideration of the following description of the preferred embodiments of the present invention taken in conjunction with the accompanying drawings.

### BRIEF DESCRIPTION OF THE DRAWINGS

Fig. 1 is a block diagram of an embodiment of the wireless access system of the present invention;
Fig. 2 is a block diagram of a WUSB device constituting the embodiment of the wireless access system of the present invention;
Fig. 3 is a block diagram of a WUSB host constituting the embodiment of the wireless access system of the present invention;
Fig. 4 is a timing diagram of a first operational example of the embodiment of the wireless access system of the present invention; and
Fig. 5 is a timing diagram of a second operational example of the embodiment of the wireless access system of the present invention.

### DESCRIPTION OF THE PREFERRED EMBODIMENTS

Generally, the present invention provides a wireless access system largely improving communication capacity through space-division multiple access communication when transmitting from a wireless terminal in multiple wireless communication between plural wireless control stations and wireless terminal devices and preventing interferences between wireless transmission signals from the wireless control station when transmitting needs no removal of interference waves in the wireless terminal device. More particularly, the present invention relates to a wireless access system, comprising:
plural wireless control stations;
a wireless terminal device to transmit and receive data to and from the plural wireless control stations,
wherein the wireless control stations adjust with each other to reserve data transmission periods so as not to overlap with those of the other wireless control stations and transmit data in the reserved periods, and
the wireless terminal device transmits data to at least one of the wireless control stations through space-division multiple access communication.

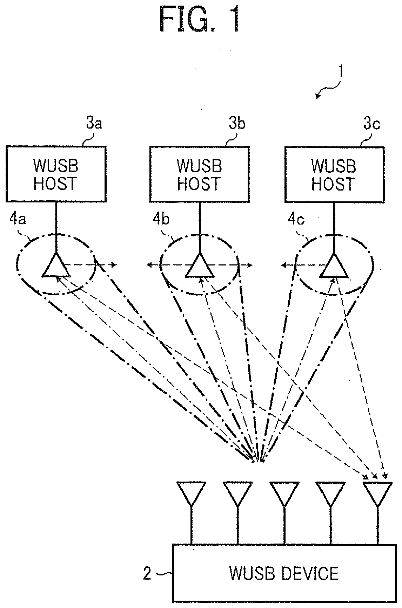

As shown in Fig. 1, an embodiment of the wireless access system of the present invention includes a WUSB device 2 and plural WUSB hosts 3a to 3c. In Fig. 1, three WUSB hosts 3a to 3c are shown, but the number of the WUSB hosts is not limited thereto.

The WUSB device 2 represents the wireless terminal device of the present invention, and includes peripheral equipment such as combined machines, printers and projectors. Each of the WUSB hosts 3a to 3c represents the wireless control station of the present invention, and includes a versatile personal computer capable of communicating with WUSB.

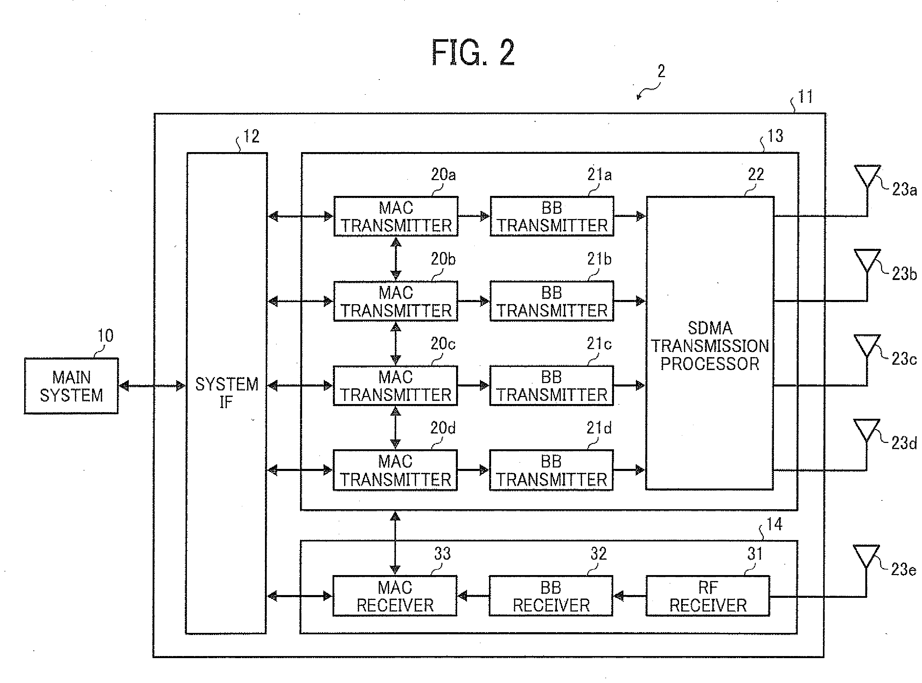

As shown in Fig. 2, the WUSB device 2 includes a main unit system 10 to control a main unit of peripheral equipment such as combined machines, printers and projectors, and a WUSB device communicator 11 to transmit and receive data to and from each of the WUSB hosts 3a to 3c.

The WUSB device communicator 11 includes a main system 10, a system IF 12 which inputs and outputs data, a SDMA transmitter 13 which transmits data to each of the WUSB hosts 3a to 3c through space-division multiple access (SDMA) communication and a TDMA receiver 14 which receives data transmitted from each of the WUSB hosts 3a to 3c through time-division multiple access (TDMA) communication.

The SDMA transmitter 13 includes media access control (MAC) transmitters 20a to 20d, baseband (BB) transmitters 21a to 21d, a SDMA transmission processor 22 and antenna elements 23a to 23d.

In Fig. 2, each four MAC transmitters 20a to 20d, BB transmitters 21a to 21d and antenna elements 23a to 23d are shown, but the numbers thereof are not limited thereto.

Each of the MAC transmitters 20a to 20d subject data input from the main system 10 through the system IF 12 to a transmission process relating to MAC layer and output the processed data to the BB transmitters 21a to 21d, respectively.

The BB transmitters 21a to 21d modulate the data input from the MAC transmitters 20a to 20d to BB signals, respectively. The SDMA transmission processor 22 duplicates each of the BB signals to the number of the transmission antenna elements, multiplies the BB signal by an adjustment factor relating to an amplitude and a phase in the direction of the WUSB hosts 3a to 3c to up-convert the signal to a radio frequency (RF) signal, and transmits the RF signals as electric waves through the antenna elements 23a to 23d, respectively.

In Fig. 1, same signals only different in amplitude and phase are transmitted from the four antenna elements, and a directive signal in the direction of the WUSB host 3a is synthesized in a space. When adjustment factor relating to an amplitude and a phase in the direction of the WUSB hosts 3b and 3c, a directive signal is synthesized as well.

The electric waves transmitted from each of the antenna elements 23a to 23d are synthesized in a space and transmitted to directional spaces 4a to 4c, respectively as Fig. 1 shows. At least one of the antenna elements 23a to 23c is located at least one of directional spaces 4a to 4c.

In Fig. 2, the TDMA receiver 14 includes a an antenna 30, an RF receiver 31 which down-converts an RF signal received through the antenna 30 to a BB signal, a BB receiver 32 which demodulates the BB signal and a MAC receiver 33 which subjects the demodulated data to a reception process relating to MAC layer and outputs the data to the main system 10 through the system IF 12. The TDMA receiver 14 can share the antenna elements 23a to 23d instead of the antenna 30 by time-division with the SDMA transmitter 13.

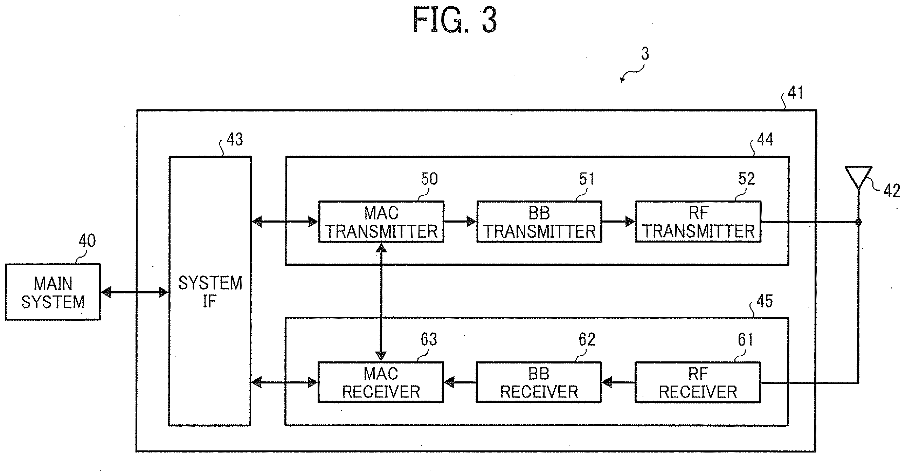

Each of the WUSB hosts 3a to 3c (hereinafter referred to as "WUSB host 3" collectively) include, as shown in Fig. 3, a main system 40 which performs a process relating to a layer prior to the MAC layer, a WUSB host communicator 41 for transmitting and receiving data to and from a WUSB device 2, and an antenna 42.

The WUSB host communicator 41 includes a system IF 43 which inputs and outputs data with the main system 40, a transmitter 44 which transmits data to the WUSB device 2 through TDMA communication and a receiver 45 which receives a directional space signal transmitted from the WUSB device 2 through TDMA communication to its own station.

The transmitter 44 includes a MAC transmitter 50, a BB transmitter 51 and an RF transmitter 52. The MAC transmitter 50 subjects data input from the main system 40 through the system IF 43 to a transmission process relating to MAC layer and outputs the processed data to the BB transmitter 51.

The BB transmitter 51 modulates data input from the MAC transmitter 50 to a BB signal. The RF transmitter 52 up-converts the BB signal to an RF signal, and transmits the RF signal as an electric wave through an antenna 42.

The receiver 45 includes an RF receiver 61 which down-converts an RF signal received through the antenna 42 to a BB signal, a BB receiver 62 which demodulates the BB signal and a MAC receiver 63 which subjects the demodulated data to a reception process relating to MAC layer and outputs the data to the main system 40 through the system IF 43.

A signal received by the antenna 42 is transmitted by the WUSB device 2 so as to have a directivity to a directional space the WUSB host 3 is located in, and a signal transmitted to the other directional spaces as an interference signal has a level considerably lower than that of a signal to its own station. Therefore, the WUSB host 3 does not need an interference wave removal process at the receiving side.

The MAC transmitters 20a to 20d and the MAC receiver 33 of the WUSB device 2, and the MAC transmitter 50 and the MAC receiver 63 of each of the WUSB hosts 3a to 3c will specifically be explained.

The MAC transmitters 20a to 20d and the MAC receiver 33 of the WUSB device 2, and the MAC transmitter 50 and the MAC receiver 63 of each of the WUSB hosts 3a to 3c perform transmission and reception process relating to MAC layer substantially according to WUSB standard using WiMedia standard (WiMedia Alliance, "MAC Specification: RELEASE 1. 5", [online], December 1, 2009, [searched on June 23, 2010], internet <URL: http://www.wimedia.org/imwp/download.asp?ContentID=16552>).

In WiMedia standard, every station (WUSB device 2 and WUSB hosts 3a to 3c) of every super frame having a cycle of 65,536 µs, formed of 256 media access slots (MAS) having a 256 µs period transmits and receives a beacon to and from each other in a beacon period at the head of the frame to synchronize time of system. Every station adjusts and reserves MAS with beacon and transmits and receives data to and from the other stations with time-division using a reserved MAS period.

A protocol which reserves MAS is called DRP (Distributed Reservation Protocol). The beacon signal includes MAS reservation request, response information (DRP IE) and present reservation status information (DRP Availability IE). Every station can always grasp the reservation status of 256 MAS with information included in the beacon signal.

In the WUSB standard, the WUSB host transmits a management frame called MMC (Micro-scheduled management Command) to a WUSB device to be controlled, and each WUSB device transmits and receives data and communication response packet to and from the WUSB host at a time designated by the MMC transmitted from the WUSB host.

Therefore, the WUSB standard using the WiMedia standard reserves MAS which is a data transmission period of the WUSB host and MAS which is a data transmission period of the WUSB device according to DRP, and transmits and receives data with the reserved MAS.

The MAC transmitters 20a to 20d of the WUSB device 2 reserve MAS which is a data transmission period according to DRP as the MAC transmitter 50 of the WUSB hosts 3a to 3c to transmit data in the same period through SDMA communication, and transmits data with the reserved MAS.

The MAC receiver 63 of each of the WUSB hosts 3a to 3c monitors MAS data reserved by MAC transmitters 20a to 20d of the WUSB device 2, and when the MAC receiver 63 detects data addressed thereto, it subjects the data to a reception process relating to MAC layer.

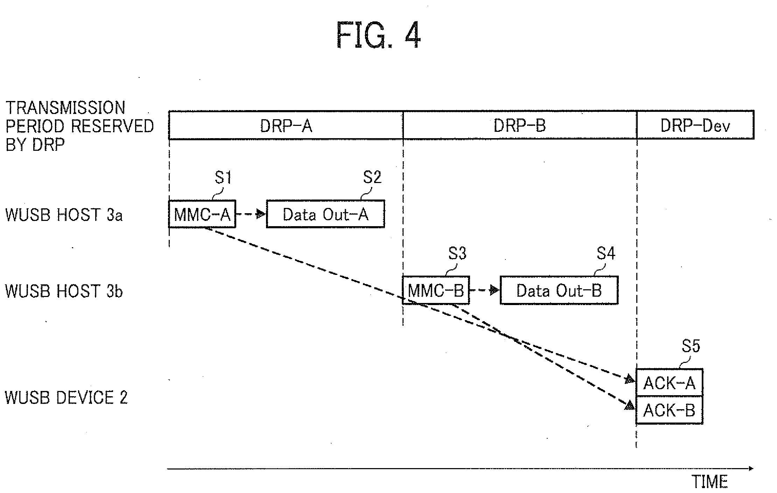

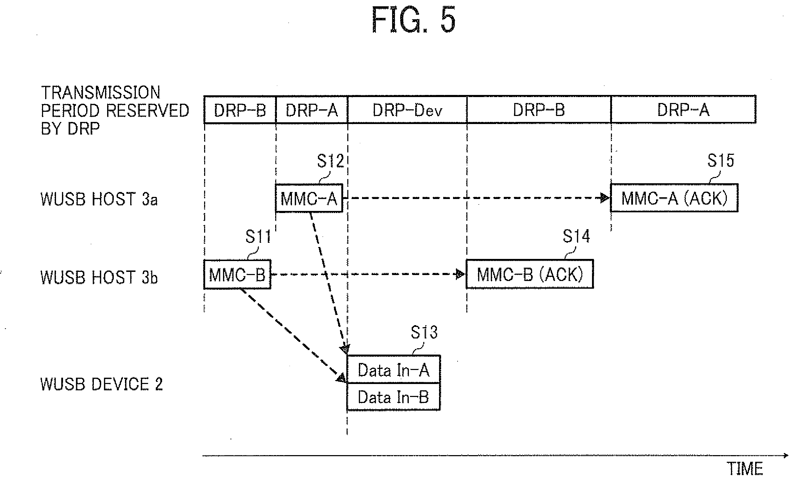

An operation example of the thus wireless access system 1 will be explained, referring to Figs. 4 and 5.

In Fig. 4, first, the WUSB host 3a transmits data, next, the WUSB host 3b transmits data, and the WUSB device 2 having received the data returns a response signal (ACK) through SDMA communication.

In Fig. 4, in one super frame of the WiMedia standard, DRP-A represents at least one MAS reserved by the MAC transmitter 50 of the WUSB host 3a, DRP-B represents at least one MAS reserved by the MAC transmitter 50 of the WUSB host 3b, and DRP-Dev represents at least one MAS reserved by the MAC transmitters 20a to 20d of the WUSB device 2.

First, in DRP-A, the MAC transmitter 50 of the WUSB host 3a transmits MMC (MMC-A in Fig. 4) including data transmission time, ACK transmission request time of the data and next MMC transmission time, and the WUSB device 2 receives this (STEP S1). The MAC transmitter 50 of the WUSB host 3a designates time in DRP-Dev as the ACK transmission request time.

At the data transmission time designated by MMC, the MAC transmitter 50 of the WUSB host 3a transmits data (Date Out-A in Fig. 4), and the WUSB device 2 receives this STEP S2).

Next, in DRP-B, the MAC transmitter 50 of the WUSB host 3b transmits MMC (MMC-B in Fig. 4) including data transmission time, ACK transmission request time of the data and next MMC transmission time, and the WUSB device 2 receives this (STEP S3). The MAC transmitter 50 of the WUSB host 3b designates time in DRP-Dev as the ACK transmission request time.

At the data transmission time designated by MMC, the MAC transmitter 50 of the WUSB host 3b transmits data (Date Out-B in Fig. 4), and the WUSB device 2 receives this STEP S4).

Next, in DRP-Dev, at the ACK transmission request time designated by each MMC, the MAC transmitters 20a to 20b of the WUSB device 2 corresponding to the directional spaces 4a and 4b where the WUSB hosts 3a and 3b are located start transmitting ACK or NACK relative to the reception result of each data, and the WUSB hosts 3a and 3b receive ACK addressed thereto (STEP S5) .

Each signal which represents ACK transmitted from the MAC transmitters 20a and 20b of the WUSB device 2 is transmitted to the directional spaces 4a and 4b by the SDMA transmitter 22 through the antenna elements 23a and 23c.

Fig. 5 represents an example where the WUSB host 3b requests for data first, the WUSB host 3a requests for data, the WUSB device 2 transmits the requested data through SDMA communication, and the WUSB hosts 3a and 3b return ACK relative to the data they received.

In Fig. 5, in a super frame in the WiMedia standard, DRP-A represents at least one MAS reserved by the MAC transmitter 50 of the WUSB host 3a, DRP-B represents at least one MAS reserved by the MAC transmitter 50 of the WUSB host 3b, and DRP-Dev represents at least one MAS reserved by the MAC transmitters 20a to 20d of the WUSB device 2.

First, in DRP-B, the MAC transmitter 50 of the WUSB host 3b transmits MMC (MMC-B in Fig. 5) including data transmission request time and next MMC transmission time including ACK relative to the data, and the WUSB device 2 receives this (STEP S11). The MAC transmitter 50 of the WUSB host 3b designates time in DRP-Dev as the data transmission request time.

Next, in DRP-A, the MAC transmitter 50 of the WUSB host 3a transmits MMC (MMC-A in Fig. 5) including data transmission request time and next MMC transmission time including ACK relative to the data, and the WUSB device 2 receives this (STEP S12). The MAC transmitter 50 of the WUSB host 3a designates time in DRP-Dev as the data transmission request time.

Next, in DRP-Dev, at the data transmission request time designated by each MMC, the MAC transmitters 20a to 20b of the WUSB device 2 corresponding to the directional spaces 4a and 4b where the WUSB hosts 3a and 3b are located start transmitting each data (Data In-A and Data In-B in Fig. 5), and the WUSB hosts 3a and 3b receive data addressed thereto (STEP S13).

Each signal which represents data transmitted from the MAC transmitters 20a and 20b of the WUSB device 2 is transmitted to the directional spaces 4a and 4b by the SDMA transmitter 22 through the antenna elements 23a and 23c.

Next, in DRP-B, at the next MMC transmission time designated by MMC-B, the MAC transmitters 50 of the WUSB host 3b transmits MMC (MMC-B (ACK) in Fig. 5) including ACK or NACK response showing data reception results from the WUSB device (STEP S14) .

Next, in DRP-A, at the next MMC transmission time designated by MMC-A, the MAC transmitters 50 of the WUSB host 3a transmits MMC (MMC-A (ACK) in Fig. 5) including ACK or NACK response showing data reception results from the WUSB device (STEP S15) .

As explained above, the wireless access system 1 of the present invention transmits data from the WUSB device 2 to the WUSB hosts 3a to 3c through SDMA communication in upbound transmission and from the WUSB hosts 3a to 3c to the WUSB device 2 through TDMA communication in downbound transmission. Therefore, in multiple wireless communication between the plural WUSB hosts 3a to 3c and the WUSB device 2, interference between wireless signals from the WUSB hosts 3a to 3c is prevented and interference wave removal process in the WUSB device 2 is not needed.

The wireless access system 1 of the present invention conjugately controls the plural WUSB hosts 3a to 3c and one WUSB device 2 using time division. Plural WUSB hosts can conjugately use a WUSB device, which is difficult for conventional WUSB standard ("wireless Universal Serial Bus Specification Revision 1.0", [online], May 12, 2005, [searched on June 23, 2010], internet <URL:http://www.usb.org/developers/wusb/wusb_2007_0214.zip> ).

The wireless access system 1 of the present invention connects the WUSB device 2 such as printers, combined machines and projectors to the plural WUSB hosts 3a to 3c such as personal computers at the same time so that they can conjugately use the WUSB device 2.

An example in which the wireless access system 1 of the present invention performs time-division duplex communication between the WUSB device 2 and the WUSB hosts 3a to 3c according to WiMedia standard has been explained. In the present invention, the wireless access system may perform time-division duplex communication between the WUSB device 2 and the WUSB hosts 3a to 3c using PCF (Point Coordination Function) control of WLAN (Wireless Local Area Network).

An example in which communication between the WUSB device 2 and the WUSB hosts 3a to 3c is made by time-division duplex communication has been explained, and in the present invention, the wireless access system of the present invention may perform frequency-division duplex communication between the WUSB device 2 and the WUSB hosts 3a to 3c.

Additional modifications and variations of the present invention are possible in light of the above teachings. It is therefore to be understood that within the scope of the appended claims the invention may be practiced other than as specifically described herein.

## Claims

1. A wireless access system (1), comprising:
plural Wireless Universal Serial Bus, WUSB, hosts (3); and a Wireless Universal Serial Bus device, WUSB device (2) configured to transmit and receive data to and from the plural WUSB hosts (3),
wherein each WUSB host (3) is configured to adjust to every other WUSB host (3) to reserve data transmission periods that do not overlap with those of the other WUSB hosts (3) and transmit data in the reserved periods under its control, and
the WUSB device (2) comprises
a time-division multiple access receiver (14) configured to receive the data transmitted by the WUSB hosts (3), using time-division multiple access communication, and
a space-division multiple access transmitter (13) provided with a plurality of MAC transmitters (20a to 20d), the space-division multiple access transmitter (13) being configured to transmit data to at least one of the WUSB hosts (3) using space-division multiple access communication,
**characterized in that**
when the WUSB device (2) receives the data using the time-division multiple access receiver (14), the space-division multiple access transmitter (13) of the WUSB device (2) is configured to transmit. ACK response signals to each of the directional spaces where the WUSB hosts (3) that have transmitted the data are located, using the plurality of MAC transmitters (20a to 20d) that correspond to said directional spaces, wherein each ACK response signal is relative to the reception result of the data received from a WUSB host and it is transmitted at an ACK transmission request time included in a Micro-scheduled management Command, MMC, received from said WUSB host.

2. The wireless access system (1) of Claim 1, wherein the WUSB device (2) adjusts to the plural WUSB hosts (3) to reserve a data transmission period that does not overlap with those of the plural WUSB hosts (3), and transmits data in the reserved period.

3. The wireless access system (1) of Claim 2, wherein the WUSB device (2) previously reserves a time band for performing space-division multiple access communication so as not to overlap with a transmission period of at least one of the WUSB hosts (3) and notifies each of the WUSB hosts (3) of the time band, each of the WUSB hosts (3) requests the WUSB device (2) under its control to transmit data and a response signal so as to be included in a time band reported from another WUSB device (2), and the WUSB device (2) transmits the data and response signal according to the transmission request from the WUSB host (3).

4. The wireless access system (1) of Claim 1, wherein the WUSB device (2) transmits data to the WUSB host (3) with a carrier wave having a frequency different from that of the data received from the WUSB host (3).

5. The wireless access system (1) of any one of Claims 1 to 4, wherein
the space-division multiple access transmitter (13) transmits different modulated signals to plural directional spaces; and
the time-division multiple access receiver (14) only receives a single modulated signal.

6. A wireless access method, comprising:
transmitting and receiving data by a Wireless Universal Serial Bus device, WUSB device (2) to and from plural WUSB hosts (3);
adjusting each of the WUSB hosts (3) to every other WUSB host (3) to reserve data transmission periods that do not overlap with those of any other WUSB host (3);
transmitting (S2, S4), by a WUSB host, data in the reserved data transmission periods under its control;
receiving, by the WUSB device (2), the data transmitted by the WUSB hosts (3), using time-division multiple access communication; and
transmitting (S5) data from the WUSB device (2) to at least one of the WUSB hosts (3) using space-division multiple access communication,
wherein
when the data is received using a time-division multiple access receiver (14), the transmitting data from the WUSB device (2) to at least one of the WUSB hosts (3) using space-division multiple access communication includes transmitting ACK response signals to each of the directional spaces where the WUSB hosts (3) that have transmitted the data are located, using a plurality of MAC transmitters (20a to 20d) that correspond to said directional spaces, wherein each ACK response signal is relative to the reception result of the data received from a WUSB host and it is transmitted at an ACK transmission request time included in a Micro-scheduled management Command, MMC, received from said WUSB host.

## Patentansprüche

1. Drahtloses Zugangssystem (1), umfassend:
mehrere drahtlose universelle serielle Bus(Wireless Universal Serial Bus, WUSB)-Hosts (3); und
eine drahtlose universelle serielle Bus-Vorrichtung, wobei die WUSB-Vorrichtung (2) konfiguriert ist, um Daten an die mehreren WUSB-Hosts (3) zu senden und Daten von diesen zu empfangen,
wobei jeder WUSB-Host (3) konfiguriert ist, um sich an jeden anderen WUSB-Host (3) anzupassen, um Datensendeperioden zu reservieren, die sich nicht mit denen der anderen WUSB-Hosts (3) überschneiden, und Daten in den reservierten Perioden unter dessen Kontrolle zu senden, und
die WUSB-Vorrichtung (2) Folgendes umfasst:
einen Zeitmultiplex-Mehrfachzugriffsempfänger (14), der konfiguriert ist, um die von den WUSB-Hosts (3) gesendeten Daten unter Verwendung der Zeitmultiplex-Mehrfachzugriffskommunikation zu empfangen, und
einen Raumteilungs-Mehrfachzugriffssender (13), der mit einer Vielzahl von MAC-Sendern (20a bis 20d) bereitgestellt ist, wobei der Raumteilungs-Mehrfachzugriffssender (13) konfiguriert ist, um Daten an mindestens einen der WUSB-Hosts (3) unter Verwendung einer Raumteilungs-Mehrfachzugriffskommunikation zu senden,
**dadurch gekennzeichnet, dass**
wenn die WUSB-Vorrichtung (2) die Daten unter Verwendung des Zeitmultiplex-Mehrfachzugriffsempfängers (14) empfängt, der Raumteilungs-Mehrfachzugriffssender (13) der WUSB-Vorrichtung (2) konfiguriert ist, um ACK-Antwortsignale an jeden der Richtungsräume zu senden, wo sich die WUSB-Hosts (3), die die Daten gesendet haben, befinden, und zwar unter Verwendung der Vielzahl von MAC-Sendern (20a bis 20d), die den Richtungsräumen entsprechen, wobei jedes ACK-Antwortsignal relativ zu dem Empfangsergebnis der von einem WUSB-Host empfangenen Daten ist und zu einer ACK-Sendeanforderungszeit gesendet wird, die in einem von dem WUSB-Host empfangenen mikroprogrammierten Verwaltungsbefehl (Micro-scheduled management Command, MMC) enthalten ist.

2. Drahtloses Zugangssystem (1) nach Anspruch 1, wobei sich die WUSB-Vorrichtung (2) an die mehreren WUSB-Hosts (3) anpasst, um eine Datensendeperiode zu reservieren, die sich nicht mit denen der mehreren WUSB-Hosts (3) überschneidet, und Daten in der reservierten Periode sendet.

3. Drahtloses Zugangssystem (1) nach Anspruch 2, wobei die WUSB-Vorrichtung (2) zuvor ein Zeitband für die Durchführung einer Raumteilungs-Mehrfachzugriffskommunikation reserviert, um nicht eine Sendeperiode von mindestens einem der WUSB-Hosts (3) zu überschneiden, und jedem der WUSB-Hosts (3) das Zeitbande mitteilt, wobei jeder der WUSB-Hosts (3) die WUSB-Vorrichtung (2) unter seiner Kontrolle auffordert, Daten und ein Antwortsignal zu senden, um in einem von einer anderen WUSB-Vorrichtung (2) gemeldeten Zeitband enthalten zu sein, und
die WUSB-Vorrichtung (2) das Daten- und Antwortsignal in Übereinstimmung mit der Sendeanforderung des WUSB-Hosts (3) sendet.

4. Drahtloses Zugangssystem (1) nach Anspruch 1, wobei die WUSB-Vorrichtung (2) Daten an den WUSB-Host (3) mit einer Trägerwelle sendet, die eine andere Frequenz aufweist als die der vom WUSB-Host (3) empfangenen Daten.

5. Drahtloses Zugangssystem (1) nach einem der Ansprüche 1 bis 4, wobei der Raumteilungs-Mehrfachzugriffssender (13) verschiedene modulierte Signale an mehrere Richtungsräume sendet; und
der Zeitmultiplex-Mehrfachzugriffsempfänger (14) nur ein einzelnes moduliertes Signal empfängt.

6. Drahtloses Zugriffsverfahren, umfassend:
Senden und Empfangen von Daten durch eine drahtlose universelle serielle Bus-Vorrichtung, WUSB-Vorrichtung (2), an und von mehreren WUSB-Hosts (3);
Anpassen jedes der WUSB-Hosts (3) an jeden anderen WUSB-Host (3), um Datensendeperioden zu reservieren, die sich nicht mit denen eines anderen WUSB-Hosts (3) überschneiden;
Senden (S2, S4) durch einen WUSB-Host von Daten in den reservierten Datensendeperioden, die unter dessen Kontrolle stehen;
Empfangen durch die WUSB-Vorrichtung (2) der von den WUSB-Hosts (3) gesendeten Daten unter Verwendung einer Zeitmultiplex-Mehrfachzugriffskommunikation; und
Senden (S5) von Daten von der WUSB-Vorrichtung (2) an mindestens einen der WUSB-Hosts (3) unter Verwendung von Raumteilungs-Mehrfachzugriffskommunikation,
wobei
wenn die Daten unter Verwendung eines Zeitmultiplex-Mehrfachzugriffsempfängers (14) empfangen werden, das Senden von Daten von der WUSB-Vorrichtung (2) an mindestens einen der WUSB-Hosts (3) unter Verwendung von Raumteilungs-Mehrfachzugriffskommunikation das Senden von ACK-Antwortsignalen an jeden der Richtungsräume umfasst, wo sich die WUSB-Hosts (3), die die Daten gesendet haben, befinden, und zwar unter Verwendung einer Vielzahl von MAC-Sendern (20a bis 20d), die den Richtungsräumen entsprechen, wobei jedes ACK-Antwortsignal relativ zum Empfangsergebnis der von einem WUSB-Host empfangenen Daten ist und zu einer ACK-Sendeanforderungszeit gesendet wird, die in einem von dem WUSB-Host empfangenen mikroprogrammierten Verwaltungsbefehl (Micro-scheduled management Command, MMC) enthalten ist.

## Revendications

1. Système d'accès sans fil (1), comprenant :
une pluralité d'hôtes bus série universel sans fil, WUSB, (3) ; et
un dispositif bus série universel sans fil, dispositif WUSB, (2) configuré pour transmettre, et recevoir, des données à, et à partir de, la pluralité d'hôtes WUSB (3),
dans lequel chaque hôte WUSB (3) est configuré pour s'ajuster à chaque autre hôte WUSB (3) pour réserver des périodes de transmission de données qui ne chevauchent pas celles des autres hôtes WUSB (3) et transmettre des données dans les périodes réservées sous son contrôle, et
le dispositif WUSB (2) comprend
un récepteur à accès multiple par répartition temporelle (14) configuré pour recevoir les données transmises par les hôtes WUSB (3), en utilisant une communication à accès multiple par répartition temporelle, et
un transmetteur à accès multiple par répartition spatiale (13) pourvu d'une pluralité de transmetteurs MAC (20a à 20d), le transmetteur à accès multiple par répartition spatiale (13) étant configuré pour transmettre des données à au moins un des hôtes WUSB (3) en utilisant une communication à accès multiple par répartition spatiale,
**caractérisé en ce que**
lorsque le dispositif WUSB (2) reçoit les données en utilisant le récepteur à accès multiple par répartition temporelle (14), le transmetteur à accès multiple par répartition spatiale (13) du dispositif WUSB (2) est configuré pour transmettre des signaux de réponse ACK à chacun des espaces directionnels où les hôtes WUSB (3) qui ont transmis les données sont situés, en utilisant la pluralité de transmetteurs MAC (20a à 20d) qui correspondent auxdits espaces directionnels, dans lequel chaque signal de réponse ACK est relatif au résultat de réception des données reçues à partir d'un hôte WUSB et il est transmis à un instant de demande de transmission ACK inclus dans une commande de gestion micro-ordonnancée, MMC, reçue à partir dudit hôte WUSB.

2. Système d'accès sans fil (1) selon la revendication 1, dans lequel le dispositif WUSB (2) s'ajuste à la pluralité d'hôtes WUSB (3) pour réserver une période de transmission de données qui ne chevauche pas celles de la pluralité d'hôtes WUSB (3), et transmet des données dans la période réservée.

3. Système d'accès sans fil (1) selon la revendication 2, dans lequel le dispositif WUSB (2) réserve auparavant une bande temporelle pour réaliser une communication à accès multiple par répartition spatiale afin de ne pas chevaucher une période de transmission d'au moins un des hôtes WUSB (3) et notifie, à chacun des hôtes WUSB (3) de la bande temporelle, chacun des hôtes WUSB (3) demande au dispositif WUSB (2) sous son contrôle de transmettre des données et un signal de réponse afin d'être inclus dans une bande temporelle rapportée à partir d'un autre dispositif WUSB (2), et
le dispositif WUSB (2) transmet les données et le signal de réponse selon la demande de transmission à partir de l'hôte WUSB (3).

4. Système d'accès sans fil (1) selon la revendication 1, dans lequel le dispositif WUSB (2) transmet des données à l'hôte WUSB (3) avec une onde porteuse ayant une fréquence différente de celle des données reçues à partir de l'hôte WUSB (3).

5. Système d'accès sans fil (1) selon l'une quelconque des revendications 1 à 4, dans lequel
le transmetteur à accès multiple par répartition spatiale (13) transmet des signaux modulés différents à une pluralité d'espaces directionnels ; et
le récepteur à accès multiple par répartition temporelle (14) reçoit seulement un signal modulé unique.

6. Procédé d'accès sans fil, comprenant :
la transmission et la réception de données par un dispositif bus série universel sans fil, dispositif WUSB, (2) à une pluralité d'hôtes WUSB (3), et à partir de celle-ci ;
L'ajustement de chacun des hôtes WUSB (3) à chaque autre hôte WUSB (3) pour réserver des périodes de transmission de données qui ne chevauchent pas celles de tout autre hôte WUSB (3) ;
la transmission (S2, S4), par un hôte WUSB, de données dans les périodes de transmission de données réservées sous son contrôle ;
la réception, par le dispositif WUSB (2), des données transmises par les hôtes WUSB (3), en utilisant une communication à accès multiple par répartition temporelle ; et
la transmission (S5) de données à partir du dispositif WUSB (2) à au moins un des hôtes WUSB (3) en utilisant une communication à accès multiple par répartition spatiale,
dans lequel
lorsque les données sont reçues en utilisant un récepteur à accès multiple par répartition temporelle (14), la transmission de données à partir du dispositif WUSB (2) à au moins un des hôtes WUSB (3) en utilisant une communication à accès multiple par répartition spatiale inclut la transmission de signaux de réponse ACK à chacun des espaces directionnels où les hôtes WUSB (3) qui ont transmis les données sont situés, en utilisant une pluralité de transmetteurs MAC (20a à 20d) qui correspondent auxdits espaces directionnels, dans lequel chaque signal de réponse ACK est relatif au résultat de réception des données reçues à partir d'un hôte WUSB et il est transmis à un instant de demande de transmission ACK inclus dans une commande de gestion micro-ordonnancée, MMC, reçue à partir dudit hôte WUSB.
